(19) Europäisches Patentamt
European Patent Office
Office européen des brevets

(11) **EP 3 338 330 B1**

(12) **FASCICULE DE BREVET EUROPEEN**

(45) Date de publication et mention de la délivrance du brevet:
**03.07.2019 Bulletin 2019/27**

(21) Numéro de dépôt: **16753665.5**

(22) Date de dépôt: **18.08.2016**

(51) Int Cl.:
*H01S 3/0941* (2006.01)   *H01S 3/223* (2006.01)
*H01S 1/06* (2006.01)

(86) Numéro de dépôt international:
**PCT/EP2016/069622**

(87) Numéro de publication internationale:
**WO 2017/029363 (23.02.2017 Gazette 2017/08)**

(54) **LASER TÉRAHERTZ, SOURCE TÉRAHERTZ ET UTILISATION D'UN TEL LASER TÉRAHERTZ**

TERAHERTZLASER, TERAHERTZQUELLE UND VERWENDUNG SOLCH EINES TERAHERTZLASERS

TERAHERTZ LASER, TERAHERTZ SOURCE AND USE OF SUCH A TERAHERTZ LASER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.08.2015 FR 1557827**

(43) Date de publication de la demande:
**27.06.2018 Bulletin 2018/26**

(73) Titulaires:
• **Centre National de la Recherche Scientifique 75794 Paris Cedex 16 (FR)**
• **Université de Lille 59800 Lille (FR)**

(72) Inventeurs:
• **LAMPIN, Jean-François 59242 Templeuve (FR)**
• **PAGIES, Antoine 59800 Lille (FR)**

(74) Mandataire: **Brevalex 95, rue d'Amsterdam 75378 Paris Cedex 8 (FR)**

(56) Documents cités:
**US-B1- 6 331 993**

• **T. Y. CHANG: "cw LASER ACTION AT 81.5 AND 263.4 [mu]m IN OPTICALLY PUMPED AMMONIA GAS", APPLIED PHYSICS LETTERS, vol. 17, no. 9, 1 janvier 1970 (1970-01-01), page 357, XP055262246, US ISSN: 0003-6951, DOI: 10.1063/1.1653432 cité dans la demande**
• **KOIZUMI TOSHIRO ET AL: "WIDE-RANGE AMPLIFICATION OF A TUNABLE DIODE LASER USING AN OPTICALLY PUMPED HIGH-PRESSURE NH3 GAS", DIGEST OF TECHNICAL PAPERS - CONFERENCE ON LASERS AND ELECTRO-OPTICS. HELD CONCURRENTLY WITH THE 13TH INTERNATIONAL QUANTUM ELECTRONICS CONFERENCE.ANAHEIM, CALIF, USA,, 1 janvier 1984 (1984-01-01), page 254, XP009189372,**
• **H TASHIRO ET AL: "Wide-range amplification of a tunable-diode laser using optically pumped high-pressure NH(3) gas", OPTICS LETTERS, vol. 9, no. 7, 1 juillet 1984 (1984-07-01), pages 279-281, XP055263310, US ISSN: 0146-9592**
• **ROLLAND C ET AL: "TUNABLE-DIODE-LASER MEASUREMENTS OF GAIN IN OPTICALLY PUMPED NH3", OPTICS LETTERS, OPTICAL SOCIETY OF AMERICA, US, vol. 8, no. 1, 1 janvier 1983 (1983-01-01), pages 36-38, XP000710412, ISSN: 0146-9592**

- HARRISON R G ET AL: "A simple and efficient optically pumped NH3 laser system", OPTICS COMMUNICATIONS, NORTH-HOLLAND PUBLISHING CO. AMSTERDAM, NL, vol. 34, no. 3, 1 septembre 1980 (1980-09-01), pages 445-446, XP022583200, ISSN: 0030-4018, DOI: 10.1016/0030-4018(80)90413-7 [extrait le 1980-09-01]
- WHITE J D ET AL: "HIGH POWER, HIGH EFFICIENCY OPTICALLY PUMPED NH3 LASERS", APPLIED PHYSICS B. PHOTOPHYSICS AND CHEMISTRY, SPRINGER VERLAG. HEIDELBERG, DE, vol. B51, no. 5, 1 novembre 1990 (1990-11-01), pages 371-373, XP000167962, DOI: 10.1007/BF00348975
- COUZI M ET AL: "Characterization of NH4Br:Cu<2+> crystals: Direct evidence of NH3 through Raman spectroscopy", SOLID STATE COMMUNICATIONS, PERGAMON, GB, vol. 91, no. 6, 1 août 1994 (1994-08-01), pages 481-485, XP024651861, ISSN: 0038-1098, DOI: 10.1016/0038-1098(94)90790-0 [extrait le 1994-08-01]

**Description**

**DOMAINE TECHNIQUE**

L'invention concerne le domaine des mesures et de l'imagerie térahertz et concerne plus particulièrement les sources d'ondes électromagnétiques qui émettent dans la gamme de fréquences du térahertz et qui permettent de telles mesures et une telle imagerie. Ces sources d'ondes électromagnétiques sont dénommées par commodité dans le reste de ce document « sources térahertz"

**ÉTAT DE LA TECHNIQUE ANTÉRIEURE**

Malgré les forts potentiels qu'elles pourraient offrir, les mesures et l'imagerie térahertz restent peu répandues ceci faute de sources optiques adéquates dans la gamme de fréquences du térahertz. En effet, dans ces fréquences d'émission comprises entre 700 et 1200 GHz, les sources d'ondes électromagnétiques continues sont relativement rares et restent relativement complexes.

En effet, ces sources térahertz peuvent être par exemple être fournies par une génération au moyen d'effet non-linéaire d'harmoniques d'une source micro-onde ou par une différence de fréquence de deux fréquences optiques. Le rendement de conversion de ces méthodes reste toutefois faible. Ces sources émettant directement dans le domaine térahertz sont les carcinotrons. Ces sources térahertz sont complexes à utiliser et sont donc peu utilisées en dehors des laboratoires de recherche. Elles nécessitent en effet un vide poussé, de hautes tensions et un fort champ magnétique qui les rendent peu compatibles avec une utilisation industrielle ou commerciale.

Une autre voie utilisée pour fournir des sources térahertz est le pompage optique d'une cavité résonnante dans laquelle se trouve un milieu amplificateur sous forme gazeux. Le pompage optique est obtenu par une source laser dite pompe.

Dans une telle configuration, pour obtenir une émission dans le térahertz, il est nécessaire que la source laser pompe et le milieu amplificateur respectent un certain nombre de critères. La longueur d'onde d'émission de la source laser pompe doit coïncider au moins partiellement avec une énergie d'excitation des molécules du milieu amplificateur d'un état initial vers un état excité. Cet état excité doit être un état dans lequel les molécules du milieu amplificateur sont susceptibles de se désexciter par une transition dont l'énergie correspond à une fréquence d'émission comprise entre 700 et 1200 GHz. De cette manière, et avec une cavité résonnante présentant des dimensions adéquates, la source laser pompe permet, par un placement d'une partie des molécules du milieu amplificateur dans l'état excité, de fournir une inversion de population pour générer un effet laser dans la cavité résonnante.

Dans une configuration classique, c'est-à-dire en utilisant un pompage optique avec une seule source laser pompe et sans stresser le milieu amplificateur autrement que par le pompage optique, il existe peu de sources optiques aux alentours de la gamme de fréquences du térahertz. On peut ainsi citer par exemple les sources commerciales fournies par Edinburgh Instruments® qui utilisent une cavité résonnante qui peut utiliser des milieux amplificateurs tels que du difluorométhane et de l'acide méthanoïque qui fournisse une émission à des fréquences respectives de 1627 GHz et 693 GHz qui ne sont pas comprises dans la gamme de fréquence du térahertz. Si certaines de ces sources peuvent être des sources térahertz, elles présentent néanmoins généralement des rendements faibles, liés à un faible accord en longueur d'onde entre les raie d'émission de la source pompe, classiquement un laser $CO_2$, et le niveau énergétique à exciter du milieu amplificateur.

Dans la gamme de fréquence du térahertz, on connait par contre la source térahertz décrite par Chang et ses co-auteurs dans leurs travaux publiés dans la revue scientifique « Applied Physic Letters », vol. 17, pages 357 à 358 en 1970 qui permet de bénéficier d'un bon accord en longueur d'onde entre la source pompe et le niveau énergétique à exciter.

Cette source térahertz comporte une cavité pompée optiquement au moyen d'un laser au protoxyde d'azote, le milieu amplificateur de la cavité étant de l'ammoniac gazeux. Le rayonnement pompe du laser au protoxyde d'azote permet de placer les molécules d'ammoniac dans un état excité dans lequel elles sont susceptibles de se désexciter dans un état intermédiaire par une transition de rotation. L'énergie de cette transition de rotation correspond à une fréquence d'émission de 3,68 THz. Les molécules d'ammoniac dans cet état intermédiaire sont alors susceptibles de se désexciter par une transition dite « d'inversion » d'énergie correspond à une fréquence d'émission de 1,14 THz (phénomène connu sous le nom de « cascade de transitions »). Cette transition d'inversion est possible grâce à l'effet tunnel qui permet à l'atome d'azote de passer à travers le triangle formé par les trois atomes d'hydrogène (la molécule $NH_3$ de forme pyramidale se renverse à la manière d'un parapluie). Ainsi, avec la cavité proposée par Chang et ses co-auteurs, une telle source térahertz permet de fournir une double émission dont l'une des fréquences d'émission est comprise dans la gamme de fréquences du térahertz. Néanmoins, cette source présente un rendement faible, puisqu'elle utilise une cascade de transition, et ne donne accès, dans la gamme du térahertz, qu'à la seule fréquence d'émission de 1,14 THz.

Afin de pallier ce problème d'accord en longueur d'onde entre la source pompe et le niveau énergétique à exciter du milieu amplificateur, il existe également des sources optiques dans la gamme de fréquences du térahertz présentant des configurations moins classiques, exploitant des phénomènes tels que l'effet Stark ou un pompage optique à deux photons. Si ces sources optiques ne sont pas limitées à une seule fréquence d'émission dans la gamme du térahertz comme c'est le cas pour la configuration classique proposée par Chang et ses co-auteurs, elles sont relativement complexes. En effet, l'exploitation de l'effet Stark nécessite à la fois d'appliquer un fort champ électrique au milieu amplificateur -tandis que le pompage optique à deux photons nécessite deux sources distinctes et présente un rendement relativement faible par rapport à un pompage à un seul photon.

De plus, si des travaux récents, comme ceux de Belkin et ses co-auteurs publiés dans la revue scientifique « Nature Photonics », volume 1, pages 288 à 292 ou encore ceux de Q. Y. Lu et ses co-auteurs publiés dans la revue scientifique « Applied Physics Letters », vol. 101, page 251121(1-4) en 2012, ont démontré la possibilité de fournir des sources optiques dont la fréquences d'émission est dans la gamme des térahertz en utilisant une génération par différence de fréquence intracavité avec deux lasers à cascade quantique, ces sources optiques émettent à des fréquences d'émission de 1 à 5 THz. Néanmoins, ces sources présentent un rendement de conversion qui baisse fortement dans la gamme du térahertz et sont donc peu, voire pas, exploitables.

Ainsi, actuellement, pour effectuer des mesures et l'imagerie térahertz dans la gamme de fréquences du térahertz, il n'existe pas un type de sources optiques continues qui soit à la fois simple, et donc n'utilise pas d'effet tel que l'effet Stark ou un pompage à double photons et nécessite une faible température, et qui donne accès à plusieurs fréquences d'émission dans cette gamme de fréquences, la source térahertz de Chang et de ses co-auteurs, par exemple, ne donnant accès qu'à une fréquence d'émission de 1,14 THz. On notera, de plus que la source térahertz de Chang et de ses co-auteurs ne permet pas d'obtenir une émission dans les gammes de fréquences autour de 850, 940 et 1040 GHz pour lesquelles les pertes dans l'atmosphère sont relativement contenues puisqu'inférieures à 0,5 dB/m.

## EXPOSÉ DE L'INVENTION

La présente invention vise à remédier à ces inconvénients et a ainsi pour but de fournir une source térahertz qui soit simple et donne accès à plusieurs fréquences discrètes d'émission dans la gamme de fréquences du térahertz.

L'invention a également pour but de fournir une source térahertz qui soit simple et qui donne accès à une émission dans la gamme de fréquences du térahertz à des fréquences inférieures à 1060 GHz et notamment aux gammes de fréquences autour de 850, 940 GHz et 1040 GHz

Il doit être entendu, ci-dessus et dans le reste de ce document, par gammes de fréquences autour de 850 GHz, 940 GHz et 1040 GHz, les gammes de fréquences dont les fréquences présentent une différence de fréquence avec ladite de valeur de fréquence inférieure ou égale à 20 GHz. Ainsi, par exemple, la gamme de fréquences autour de 850 GHz correspond aux fréquences v respectant l'inégalité suivante :

L'invention est définie dans la revendication 1 ; des modes particuliers de réalisation apparaissent dans les revendications 1-12.

Un tel laser térahertz, utilisant directement les transitions d'inversion des molécules d'ammoniac, donne accès à de nombreuses de fréquences d'émission réparties sur toute la plage de fréquences du térahertz. En effet, les transitions par inversion de l'ammoniac, si l'on prend une excitation du seul mode de vibration $v_2$ par la branche Q, donne accès à plus de 85 raies d'émission pour un laser selon l'invention avec une différence de fréquence moyenne et maximale, entre deux raies accessibles qui se succèdent, de respectivement de1 GHz et 480 GHz. De plus l'utilisation d'une source laser à semiconducteur, qui présente l'avantage, contrairement aux sources laser infrarouge à gaz, de pouvoir émettre à un nombre d'onde spécifique voire même être accordable en nombre d'onde, permet de choisir spécifiquement la transition d'inversion qui sera excitée dans la cavité résonnante.

Ainsi, le laser selon l'invention permet de fournir une source térahertz dans la gamme de fréquences du térahertz qui permet, par une adaptation adéquate de sa cavité résonnante et de sa source laser infrarouge, d'obtenir un rayonnement dont la fréquence peut être choisie dans un nombre important de fréquences discrètes d'émission dans la gamme de fréquences du térahertz. Un tel laser rend donc envisageable de nombreuses applications optiques dans la gamme du térahertz telles que les mesures et l'imagerie térahertz.

On notera de plus qu'une émission dans la gamme du térahertz générée par une transition d'inversion pure de l'ammoniac permet d'avoir accès à des raies d'émission correspondant à des fréquences d'émission inférieures à 1060 GHz et notamment aux gammes de fréquences autour de 850, 940 et 1040 GHz. De telles raies d'émission sont particulièrement avantageuses du fait de leur faible absorption dans l'atmosphère et dont par rapport aux possibilités de mesures à l'atmosphère qu'elles offrent.

Il est rappelé qu'une molécule d'ammoniac $NH_3$ dans son état fondamental présente 4 modes de vibration accessibles, dont deux sont dégénérés :

- le mode $v_1$, qui correspond à l'élongation vibration symétrique (A1) des liaisons NH,

- le mode $v_2$, qui correspond à la déformation angulaire symétrique (A1) des liaisons NH,
- les modes $v_{3a}$ et $v_{3b}$, qui correspondent à l'élongation antisymétrique doublement dégénérée (E) des liaisons NH,
- les modes $v_{4a}$ et $v_{4b}$, qui correspondent à la déformation angulaire doublement dégénérée (E) entre les liaisons NH.

A chaque mode de vibration correspond un certain nombre d'états de rotation accessibles pour la molécule d'ammoniac qui sont qualifiés par deux paramètres qui sont J et K. Ces états sont eux-mêmes dédoublés par l'effet tunnel en deux symétries possibles : les états symétriques (s) et les états antisymétriques (a). Ainsi, un état de vibration du mode de vibration $v_2=1$ s'écrira respectivement $v_2=1$ s(J,K) s'il est symétrique et $v_2=1$ a(J,K) s'il est antisymétrique avec J le nombre quantique qui définit le moment angulaire rotationnel de la molécule et K le nombre quantique qui définit la composante vectorielle du moment angulaire rotationnel suivant l'axe principal de symétrie de la molécule. J est un nombre quantique positif, donc un entier naturel. K étant la projection de J sur l'axe de symétrie de la molécule, il est un entier relatif compris entre -J et +J. Chaque état de vibration-rotation-symétrie correspond à un niveau énergétique. Ainsi lorsque l'on quantifie l'état d'une molécule d'ammoniac, il peut être fait mention aussi bien de l'état de vibration-rotation-symétrie de la molécule que du niveau énergétique dans lequel elle se trouve.

Il est également rappelé qu'une transition optique infrarouge d'un mode de vibration-rotation-symétrie de la molécule d'ammoniac à un autre mode de vibration-rotation-symétrie de la molécule d'ammoniac pour une bande parallèle comme $v_2$ doit respecter les conditions (règles de sélection) suivantes : $\Delta v$=-1 ou +1, $\Delta K$=0, $\Delta J$=-1, 0 ou +1, et a←s ou s←a. Ces trois types de transitions, ou branches, sont dites respectivement, transition de la branche P si $\Delta J$=-1, transition de la branche Q si $\Delta J$=0 et transition de la branche R si $\Delta J$=+1.

Dans un mode de vibration-rotation-symétrie donné une molécule d'ammoniac est susceptible de se désexciter par différentes transitions. Ainsi, dans le cas de l'invention, une molécule susceptible de se désexciter par une transition d'inversion dite « pure » est une molécule qui est susceptible se désexciter d'un état de vibration du type a(J,K), donc antisymétrique, en un état de vibration s(J,K), donc symétrique l'état vibrationnel et de rotation ne changeant pas ($\Delta v$=0, $\Delta K$=0, $\Delta J$=0). Ainsi dans le cadre de l'invention, la source laser est apte à exciter une molécule d'ammoniac d'un état initial $v_x=0$ s(J,K) (x étant choisi dans parmi 1, 2, 3a, 3b, 4a, 4b) dans un état vibrationnel excité du type $v_x=1$ a(J,K), une telle transition est donc une transition de la branche Q. Dans cet état vibrationnel excité, la molécule d'ammoniac est susceptible de se désexciter par une transition d'inversion pure dans un état vibrationnel $v_x=1$ s(J,K). Une telle transition est une transition directe, c'est-à-dire que la molécule est susceptible de se désexciter directement par une transition d'inversion dans l'état vibrationnel $v_x=1$ s(J,K). La molécule lors de cette désexcitation passe donc directement de l'état vibrationnel dans lequel elle a été excitée par le pompage optique dans un état vibrationnel de plus basse énergie par une transition d'inversion pure sans passer par un état vibrationnel intermédiaire.

Il est également à noter que l'ammoniac gazeux dans le milieu amplificateur peut être de deux types d'isotope, l'ammoniac $^{14}NH_3$ dont l'azote est l'isotope 14 et l'ammoniac $^{15}NH_3$ dont l'azote est l'isotope 15. Bien entendu, chacun de ces types d'isotope de l'ammoniac comporte des énergies d'état vibrationnel qui lui sont propres. Une telle isotopie de la molécule d'ammoniac permet donc de doubler le nombre de raies d'émissions accessibles par un laser selon l'invention dans la gamme du térahertz.

La source laser infrarouge peut être un laser à cascade quantique.

Une telle source laser semiconductrice est particulièrement adaptée pour fournir un rayonnement pompe efficace à une longueur d'onde infrarouge apte à exciter les molécules du milieu amplificateur avec un bon accord en longueur d'onde entre la source laser et le niveau énergétique à exciter du milieu amplificateur. En effet, de tels lasers à cascade quantique peuvent aisément être rendus accordables en longueur d'onde pour assurer un tel accord en longueur d'onde. Si l'on ajoute à cela les fortes puissances accessibles avec de telles sources, qui peuvent de plus être combinées entre elles, elles permettent d'assurer un bon pompage optique de la cavité résonnante et donc une émission térahertz efficace.

Le laser térahertz peut être adapté pour émettre au moins un deuxième rayonnement électromagnétique dont une deuxième fréquence d'émission est comprise entre 700 GHz et 1200 GHz, dans lequel la source laser infrarouge est un laser à cascade quantique accordable sur une plage de longueurs d'onde comportant au moins deux longueurs d'onde aptes à exciter les molécules du milieu amplificateur du niveau énergétique initial vers respectivement le premier et un deuxième niveau énergétique excité, les molécules du milieu amplificateur placées dans ce deuxième niveau énergétique excité étant susceptibles de se désexciter par une transition d'inversion pure liée au mode de renversement de type parapluie de la molécule d'ammoniac dont l'énergie de désexcitation correspond à la deuxième fréquence d'émission,
la cavité résonnante présentant au moins une configuration pour laquelle la cavité résonnante est une cavité résonnante à la deuxième fréquence d'émission.

Un tel laser térahertz permet de fournir une source térahertz modulable puisqu'elle est apte à fournir au moins deux fréquences d'émission dans le térahertz avec une seule configuration. En effet la cavité et la source laser infrarouge étant toutes deux accordables, les émissions laser à ces deux fréquences présentent toutes deux une bonne efficacité. On notera que cela est particulièrement avantageux vis-à-vis des sources térahertz de l'art antérieur qui sont généralement adaptées pour émettre à une seule fréquence d'émission.

Le premier niveau énergétique excité par la source laser infrarouge peut être un niveau énergétique de vibration $v_2$=1 accessible par une transition de la branche Q avec un nombre quantique J inférieur à 10.

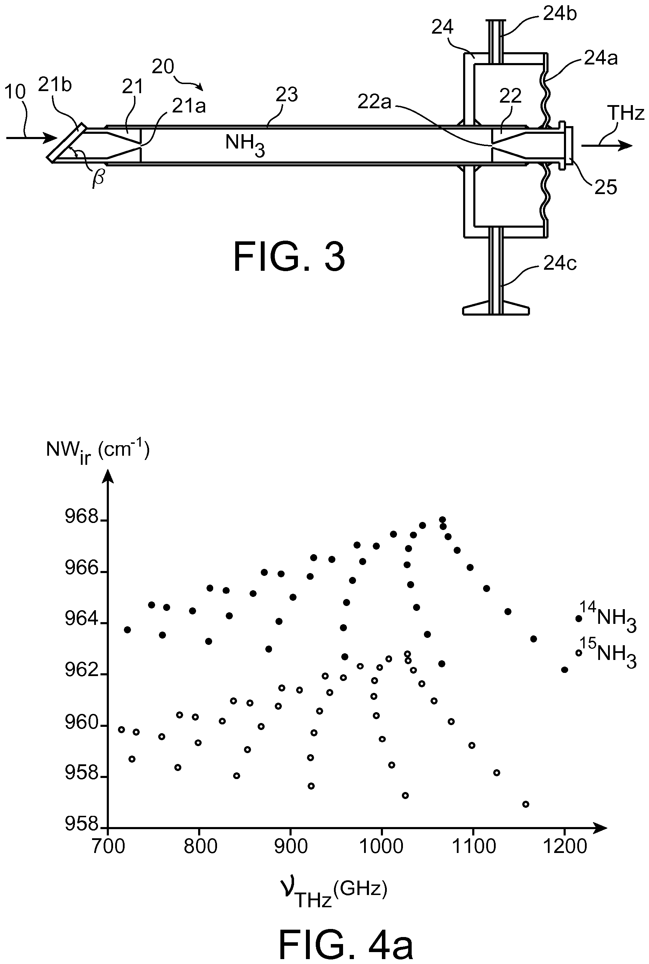

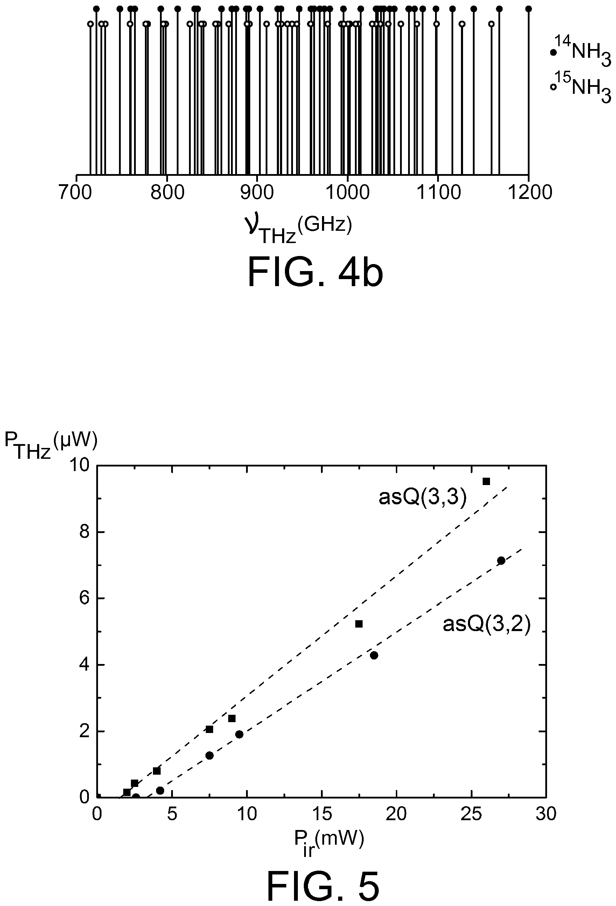

Un tel niveau énergétique est particulièrement avantageux puisqu'il donne accès avec un bon rendement d'émission à un grand nombre de fréquences d'émission comprises dans la gamme du térahertz. Ainsi et comme illustré sur les figures 4a et 4b, même avec un seul type d'ammoniac, que ce soit l'ammoniac dont l'azote est l'isotope 14 ou l'ammoniac dont l'azote est l'isotope 15, il est possible de fournir un laser térahertz selon l'invention avec une fréquence d'émission choisie dans la gamme du térahertz ceci sans être réellement limité dans le choix de cette fréquence. En effet deux fréquences d'émission accessibles consécutives présentent une différence qui est inférieure à 30 GHz et qui est égale, en moyenne, à 15 GHz.

L'ammoniac gazeux est choisi dans le groupe comportant l'ammoniac dont l'atome d'azote est l'isotope 14, l'ammoniac dont l'atome d'azote est l'isotope 15 et leur mélange,
et dans lequel la proportion volumique relative dans le milieu amplificateur de l'un parmi l'ammoniac dont l'atome d'azote est l'isotope 14 et l'ammoniac dont l'atome d'azote est l'isotope 15 est supérieure à 90% et préférentiellement à 95%.

Avec un tel mélange gazeux en tant que milieu amplificateur, l'émission est particulièrement efficace puisque la grande majorité des molécules du milieu amplificateur sont susceptible de participer à l'émission.

L'ammoniac gazeux peut être un mélange d'ammoniac dont l'atome d'azote est l'isotope 14 et d'ammoniac dont l'atome d'azote est l'isotope 15, les proportions volumiques relatives dans le milieu amplificateur de l'ammoniac dont l'atome d'azote est l'isotope 14 et l'ammoniac dont l'atome d'azote est l'isotope 15 étant toutes deux comprises entre 40 et 60%.

Avec un tel mélange gazeux, la source laser donne un accès un grand nombre de fréquences d'émission puisque les fréquences d'émission de l'ammoniac dont l'atome d'azote est l'isotope 14 et de l'ammoniac dont l'atome d'azote est l'isotope 15 sont accessibles.

L'ammoniac gazeux peut être un mélange d'ammoniac dont l'atome d'azote est l'isotope 14 et d'ammoniac dont l'atome d'azote est l'isotope 15, la cavité résonnante étant configurée pour permettre une modification des proportions volumiques relatives dans le milieu amplificateur de l'ammoniac dont l'atome d'azote est l'isotope 14 et l'ammoniac dont l'atome d'azote est l'isotope 15.

Une telle source laser permet, en offrant la possibilité de modifier la composition du milieu amplificateur, de permettre de choisir aisément la fréquence d'émission parmi celles offertes par l'ammoniac dont l'atome d'azote est l'isotope 14 et par l'ammoniac dont l'atome d'azote est l'isotope 15 tout en gardant une efficacité d'émission qui reste entière.

Le laser térahertz peut comporter au moins une fibre optique infrarouge, telle qu'une fibre optique creuse, comprenant une première et une deuxième extrémité, la première extrémité étant connectée à la sortie de la source laser infrarouge et la deuxième extrémité étant connectée à la cavité résonnante de manière à fournir une liaison optique entre la source laser infrarouge et la cavité résonnante.

On entend ci-dessus et dans le reste de ce document parfibre optique infrarouge, une fibre optique adaptée pour transmettre les rayonnements électromagnétiques compris dans la gamme des infrarouges. On notera ainsi qu'une fibre optique infrarouge peut être une fibre optique creuse, une fibre optique à verre de chalcogénure ou une fibre optique microstructurée.

La source laser infrarouge peut être adaptée pour émettre un rayonnement pompe pour pomper optiquement la cavité résonnante,
et dans lequel la cavité résonnante peut comporter une entrée pour l'injection du rayonnement pompe dont les dimensions sont inférieures à $c$/1,706$f$ avec c la vitesse de la lumière et f la première fréquence d'émission, les dimensions de l'entrée pour l'injection du rayonnement pompe étant préférentiellement inférieures à $c$/2$f$.

L'entrée pour l'injection du rayonnement pompe peut avoir des dimensions inférieur à 176 μm.

La sortie de la source laser infrarouge peut être positionnée au niveau de l'entrée de la cavité résonnante.

De telles configurations permettent de fournir un laser selon l'invention avec un couplage optique optimisé.

On entend ci-dessus et dans le reste de ce document par une sortie de la source infrarouge placée « au niveau de l'entrée de la cavité résonnante» que ladite sortie est disposée par rapport à ladite entrée de manière à ce que l'entrée intercepte la totalité du cône d'émission du rayonnement infrarouge sortant par la sortie de la source laser infrarouge. Plus généralement, une telle caractéristique correspond à une sortie de la source laser infrarouge alignée avec l'axe optique de la cavité résonnante à une distance de l'entrée de l'entrée de la cavité résonnante inférieure au centimètre

La cavité résonnante peut comporter une lentille convergente agencée pour diminuer la divergence du rayonnement pompe en sortie de la fenêtre d'entrée.

Une telle lentille permet d'assurer un bon pompage optique du milieu amplificateur.

L'invention concerne en outre une source térahertz adaptée pour émettre au moins un troisième rayonnement électromagnétique dont une troisième fréquence d'émission est comprise entre 700 GHz et 1200 GHz, la source térahertz comportant :

- Un laser térahertz selon l'invention,
- une source hyperfréquence apte à émettre un rayonnement hyperfréquence dont la fréquence d'émission est comprise entre 1 GHz et 200 GHz,
- un milieu ou dispositif non linéaire agencé pour mélanger le premier rayonnement térahertz fourni par la source laser térahertz et le rayonnement hyperfréquence pour fournir le troisième rayonnement.

Une telle source permet de fournir un troisième rayonnement dont la fréquence d'émission peut précisément être choisie dans la gamme du térahertz ceci grâce au décalage en fréquence offert par l'utilisation du milieu ou dispositif non linéaire.

L'invention concerne en outre l'utilisation d'un laser térahertz selon l'invention pour effectuer de l'imagerie, de la spectroscopie, de la transmission de données ou de la détection d'obstacles dans la gamme du térahertz

Une telle utilisation bénéficie des possibilités d'accordabilité et de bon rendement offert par un laser selon l'invention.

**BRÈVE DESCRIPTION DES DESSINS**

La présente invention sera mieux comprise à la lecture de la description d'exemples de réalisation, donnés à titre purement indicatif et nullement limitatif, en faisant référence aux dessins annexés sur lesquels :

- la figure 1 illustre schématiquement un laser selon un premier mode de réalisation de l'invention,
- la figure 2 illustre les diagrammes énergétiques de deux transitions énergétiques de la molécule d'ammoniac susceptibles d'être utilisées dans un laser selon l'invention,
- la figure 3 illustre un exemple de configuration de la cavité résonnante d'un laser selon l'invention,
- les figures 4a et 4b illustrent respectivement un graphique des fréquences d'émission accessibles pour un laser selon l'invention par une transition d'inversion, ceci en fonction du nombre d'onde de la source laser infrarouge employée pour pomper la cavité résonnante, et une frise en fréquences sur laquelle sont représentées les différentes fréquences d'émission accessibles au moyen d'une transition d'inversion, ceci pour les deux isotopes de l'ammoniac,
- la figure 5 est un graphique illustrant expérimentalement la puissance d'émission d'un laser selon l'invention en fonction de la puissance de la source laser infrarouge pompant la cavité résonnante pour deux modes de vibration-rotation de la molécule d'ammoniac,
- la figure 6 illustre un exemple de couplage optique entre la cavité résonnante et le laser pompe au moyen d'une fibre optique selon un deuxième mode de réalisation,
- la figure 7 illustre un autre exemple de couplage optique entre la cavité résonnante et le laser pompe au moyen d'une fibre optique selon un troisième mode de réalisation dans lequel la cavité résonnante comporte une lentille convergente,
- la figure 8 illustre un laser selon un quatrième mode de réalisation dans lequel la cavité résonnante comporte une ouverture faisant office d'entrée par laquelle est introduit le rayonnement pompe émis par la source laser infrarouge et dans lequel la sortie de la source laser est positionnée au niveau de l'entrée,
- la figure 9 illustre une source térahertz comportant un laser térahertz selon l'invention et une source hyperfréquence dont les émissions respectives sont combinées au moyen d'un milieu ou dispositif non linéaire.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

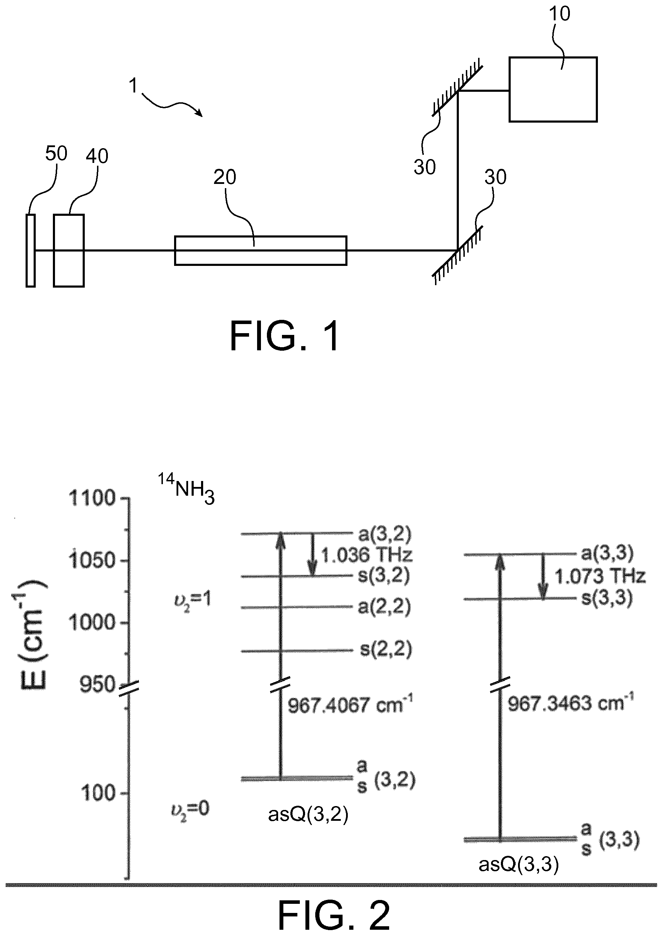

La figure 1 illustre schématiquement un laser térahertz 1 selon l'invention. Un tel laser térahertz 1 est adapté pour émettre au moins un premier rayonnement électromagnétique dont une première fréquence d'émission est comprise dans la gamme de fréquences du térahertz comprise entre 700 GHz et 1200 GHz. Ce laser térahertz 1 est plus particulièrement dédié aux mesures et/ou l'imagerie térahertz tel que cela est illustré sur la figure 1 sur laquelle est figuré un échantillon 40 soumis au rayonnement du laser térahertz un détecteur THz 50 pour détecter le rayonnement THz issu de cette soumission.

Le laser térahertz 1 comporte :

- une source laser infrarouge 10,
- une cavité résonnante 20 agencée pour être pompée optiquement par la source laser infrarouge 10, ladite cavité résonnante contenant de l'ammoniac gazeux $NH_3$ en tant que milieu amplificateur.

La source laser infrarouge 10 est une source laser continue à semiconducteur apte à exciter les molécules du milieu amplificateur d'un niveau énergétique initial vers au moins un premier niveau énergétique excité, les molécules du milieu amplificateur placées dans ce premier niveau énergétique excité étant susceptibles de se désexciter par une transition d'inversion pure dont l'énergie de désexcitation correspond à la première fréquence d'émission.

Le premier niveau énergétique excité est, pour qu'une molécule placée dans ce dernier soit susceptible de se désexciter spontanément par une transition d'inversion, un niveau énergétique correspondant à un état de vibration antisymétrique du type a(J,K) depuis lequel la molécule est susceptible de se désexciter dans un niveau énergétique correspondant à un état de vibration symétrique du type s(J,K).

Dans une application usuelle de l'invention, le premier niveau énergétique excité par la source laser infrarouge 10 est un niveau énergétique accessible par une transition de la branche Q avec un J, le nombre quantique qui définit le moment angulaire rotationnel de la molécule, inférieur à 10. Le mode de vibration dans lequel les molécules d'ammoniac sont excitées dans cette application usuelle de l'invention est le mode de vibration $v_2$.

Le principe d'une telle adaptation de la source laser infrarouge 10 est illustré sur la figure 2 dans le cas où la cavité résonnante comporte de l'ammoniac dont l'azote d'isotope 14. Ainsi, si on prend l'exemple à gauche de la figure 2, la source laser infrarouge 10 peut être un laser infrarouge présentant au moins une configuration dans laquelle son nombre d'onde d'émission est égal à 967,4067 $cm^{-1}$. Avec un tel nombre d'onde, le rayonnement pompe émis par la source laser infrarouge 10 est apte à exciter les molécules d'ammoniac de la cavité résonnante se trouvant dans un état fondamental $v_2=0$ s(3,2) à un niveau excité $v_2=1$ a(3,2). Les molécules d'ammoniac dans ce niveau énergétique sont susceptibles de se désexciter par une transition d'inversion pure dans un niveau excité $v_2=1$ s(3,2). Lors de cette désexcitation, un photon correspondant à l'énergie de cette transition d'inversion pure est émis. La fréquence d'émission de ce photon, correspondant à la première fréquence, est de 1,036 THz et est comprise dans la gamme du térahertz.

De la même façon, si on prend l'exemple à droite de la figure 2, la source laser peut être une source laser infrarouge présentant au moins une configuration dans laquelle son nombre d'onde d'émission est égal à 967,3463 $cm^{-1}$. Avec un tel nombre d'onde, le rayonnement pompe émis par la source laser infrarouge 10 est apte à exciter les molécules d'ammoniac de la cavité résonnante se trouvant dans un état fondamental $v_2=0$ s(3,3) à un niveau excité $v_2=1$ a(3,3). Les molécules d'ammoniac dans ce niveau énergétique sont susceptibles de se désexciter par une transition d'inversion puredans un niveau excité $v_2=1$ s(3,3). Lors de cette désexcitation, un photon correspondant à l'énergie de cette transition d'inversion est émis. La fréquence d'émission de ce photon, correspondant à la première fréquence, est de 1,073 THz et est comprise dans la gamme du térahertz.

Afin de fournir une telle adaptation, selon une première possibilité de l'invention, la source laser peut être une source laser accordable adaptée pour émettre dans une gamme de longueurs d'onde au moins partiellement contenue dans la gamme des infrarouges. Cette gamme de longueurs d'onde comprend le nombre d'onde d'émission pour exciter les molécules du milieu amplificateur du niveau énergétique initial vers le premier niveau énergétique excité. Ainsi, selon les exemples de la figure 2, la source laser infrarouge 10 est accordable dans une gamme de longueurs d'onde comprenant respectivement le nombre d'onde d'émission de 967,4067 $cm^{-1}$ et de 967,3463 $cm^{-1}$.

Pour permettre une telle possibilité, la source laser infrarouge 10 peut être un laser à cascade quantique accordable dans les infrarouges et notamment dans une plage de longueurs d'onde au moins partiellement comprise dans la plage de longueurs d'onde correspondant aux nombres d'onde d'émission allant de 955 à 970 $cm^{-1}$.

Selon une deuxième possibilité, la source laser infrarouge 10 peut être un laser adapté pour émettre une seule longueur d'onde dans la gamme des infrarouges, cette longueur d'onde correspondant au nombre d'onde d'émission pour exciter les molécules du milieu amplificateur du niveau énergétique initial vers le premier niveau énergétique excité. Ainsi, selon les exemples de la figure 2, la source laser infrarouge, selon cette deuxième possibilité, émet à un nombre d'onde d'émission de 967,4067 $cm^{-1}$ ou de 967,3463 $cm^{-1}$.

Selon une variante de l'invention applicable à ces deux possibilités, la source laser infrarouge peut également être un laser à semiconducteur du type à diode comme par exemple un laser à sel de plomb ou d'un ou plusieurs lasers à semiconducteur de type à diode proche infrarouge suivi d'un système de conversion nonlinéaire dont au moins une longueur d'onde d'émission est une longueur d'onde correspondant à un nombre d'onde d'émission compris entre 955 à 970 $cm^{-1}$. En d'autre termes, la longueur d'onde est comprise dans la gamme de longueur d'onde allant de 10.309 $\mu m$ à 10.471 $\mu m$.

La sortie de la source laser infrarouge 10 est couplée optiquement à la cavité résonnante 20 de manière à permettre son pompage optique. Dans le premier mode de réalisation, comme cela est illustré sur la figure 1, le couplage optique entre la sortie de la source laser infrarouge 10 et la cavité résonnante 20 est réalisé au moyen de deux miroirs 30 qui guident le rayonnement de pompage émis par la source laser en direction de la cavité résonnante 20.

La cavité résonnante 20 est une cavité résonnante à la première fréquence d'émission. La figure 3 illustre un exemple de configuration de cavité résonnante 20 selon le premier mode de réalisation.

La cavité résonnante 20 comporte :

- une paroi latérale tubulaire 23 délimitant l'intérieur de la cavité résonnante 20 et formant un guide d'onde dans la gamme de longueur d'onde du térahertz,
- un premier miroir 21 fermant la paroi latérale à l'une de ses extrémités, le premier miroir 21 comportant une ouverture 21a pour l'introduction du rayonnement de pompage dans la cavité résonnante 20, ladite ouverture 21a faisant office d'entrée pour le rayonnement pompe dans la cavité résonnante 20,
- un deuxième miroir 22 fermant la paroi latérale 23 à l'autre de ses extrémités, le deuxième miroir 22 comportant une ouverture 22a pour extraire une partie des photons issus de la désexcitation des molécules du milieu amplificateur.

Le premier et deuxième miroir 21, 22 sont des miroirs au moins partiellement réfléchissant dans la gamme de longueur d'onde du térahertz et avantageusement dans une partie de la gamme des infrarouges comprenant la longueur d'onde d'émission de la source laser infrarouge. Suivant la transition excitée, les pertes de la cavité et la puissance du rayonnement pompe, le deuxième miroir 22 aura un coefficient de réflexion choisi entre 75 à 98 %. Le premier miroir 21 présente préférentiellement un coefficient de réflexion élevé, ainsi typiquement le taux de réflexion du premier miroir 21 est supérieur à 95%, voire 98%.

Le premier miroir 21 est donc préférentiellement le miroir qui présente le taux de réflexion dans la gamme du térahertz le plus important. Un tel taux plus important peut notamment être obtenu par un diamètre de l'ouverture 21a du premier miroir 21 adéquat. En effet, une telle ouverture formant un guide d'onde conducteur cylindrique, la fréquence de coupure du mode fondamental $TE_{11}$ est donnée par :

$$ f_c = \frac{c}{1{,}706d} $$

où c est la vitesse de la lumière et $d$ le diamètre de l'ouverture. Ainsi un diamètre inférieur à 176 $\mu$m permet d'éviter la propagation des fréquences inférieures à 1 THz. Ainsi, l'ouverture 21a du premier miroir, qui forme une entrée pour l'injection du rayonnement pompe, présente des dimensions inférieures à $c/1{,}706f$, les dimensions de cette même ouverture 21a étant préférentiellement inférieures à $c/2f$.

Plus généralement, pour une première fréquence d'émission f donnée, l'ouverture 21a formant l'entrée pour l'injection du rayonnement pompe présente préférentiellement un diamètre inférieure à $c/1{,}706f$. Pour une ouverture 21a du premier miroir rectangulaire ou carré, les dimensions de l'entrée de l'ouverture 21a formant l'entrée pour l'injection du rayonnement pompe, notamment ses diagonales, sont préférentiellement inférieures à $c/2f$.

Ainsi, par exemple, une ouverture circulaire de diamètre 150 $\mu$m (fréquence de coupure: 1,17 THz) permettra la transmission du faisceau infrarouge de pompe tout en interdisant la propagation dans la gamme du térahertz.

La cavité comporte également sur la figure 3, en amont du premier miroir, une fenêtre 21b transparente aux infrarouges. Cette fenêtre 21b est réalisée en bromure de potassium (KBr) ou en un autre matériau transparent dans la gamme du rayonnement de pompe comme le chlorure de sodium NaCl, le séléniure de zinc ZnSe, le silicium Si ou le germanium Ge. L'angle $\beta$ de la fenêtre 21b par rapport à l'axe optique de la cavité résonnante est choisi pour être en incidence de Brewster de manière à annuler la réflexion partielle du rayonnement pompe sur ladite fenêtre 21b.

La forme du deuxième miroir 22 est adaptée pour limiter la divergence du faisceau du rayonnement térahertz en sortie de sa fenêtre. En effet, afin de fournir un deuxième miroir avec un taux de réflexion adéquat, l'ouverture 22a du deuxième miroir est de l'ordre des longueurs d'onde correspondant à la gamme du térahertz, c'est-à-dire de l'ordre du 0,3 mm. Sans une forme adéquate permettant de faire partiellement converger le rayonnement issu du laser, la faible dimension de l'ouverture 22a du deuxième miroir 22 fait diverger le faisceau de sortie. Le deuxième miroir 22 peut, pour fournir une telle adaptation pour limiter la divergence du faisceau, présenter en sortie de l'ouverture 22a une section conique avec un diamètre extérieur augmentant régulièrement, préférentiellement monotonement, le long de l'axe optique de la cavité résonnante 20. Selon une variante de l'invention, le laser peut également comporter en aval de l'ouverture 22a du deuxième miroir 22 une lentille convergente. Selon une variante de l'invention, le miroir 22 peut également être constitué par une grille métallique, celle-ci pouvant être auto-supportée ou disposée à la surface d'un support diélectrique. Dans ce cas le couplage s'effectue sur toute la surface du miroir et permet de minimiser la divergence du faisceau. Suivant l'art antérieur cette grille peut être de type capacitif ou inductif.

La cavité résonnante 20 est conformée étanche de manière à éviter les fuites d'ammoniac et ainsi limiter les pertes d'ammoniac qui pourraient être préjudiciables à la fois pour la puissance du laser térahertz 1 et pour un technicien qui serait amené à manipuler le laser.

La paroi latérale 23 tubulaire présente une forme tubulaire longitudinale de section transversale circulaire. Bien entendu, la paroi latérale 23 peut également présenter une forme tubulaire autre sans que l'on sorte du cadre de l'invention et peut ainsi présenter, par exemple, une section transversale rectangulaire ou plus généralement polygonale ou elliptique sans que l'on sorte du cadre de l'invention. La paroi latérale 23 peut ainsi être réalisée dans un métal tel que du cuivre. Selon une possibilité de l'invention, la surface de cuivre à l'intérieur de la cavité résonnante 20 peut également être recouverte d'un diélectrique comme par exemple un polymère. Selon une autre possibilité de l'invention la paroi latérale 23 peut également être réalisée dans un diélectrique comme la silice fondue ou du verre.

Dans ce premier mode réalisation illustré sur la figure 3, le deuxième miroir 22 est monté mobile relativement au premier miroir 21. Un tel montage permet de modifier aisément la fréquence de résonance de la cavité résonnante 20.

Le montage mobile du deuxième miroir 22 est fourni par un placement du deuxième miroir 22 libre en translation à l'intérieur de la paroi latérale 23 avec une partie du deuxième miroir 22 qui fait saillie et d'une chambre étanche 24 agencée autour de la deuxième extrémité de la paroi latérale 23. Cette chambre étanche 24 comporte une cloison 24a en matériau flexible, telle qu'une membrane métallique, reliée à la partie du deuxième miroir 22 faisant saillie de la paroi latérale 23. De cette manière, la flexibilité offerte par la cloison 24a flexible, permet un déplacement du deuxième miroir 22 et permet, pour une source laser infrarouge 10 accordable, d'exploiter plusieurs transitions d'inversion de l'ammoniac.

Ce montage mobile illustré sur la figure 3 n'est donné qu'à titre d'exemple et n'est bien entendu pas limitatif de l'invention. L'invention englobe tout type de montage du premier et du deuxième miroir 21, 22 dans lequel le deuxième miroir 22 est mobile relativement au premier miroir 21. Ainsi par exemple, l'invention englobe également la possibilité non illustrée selon laquelle la paroi latérale 23 comporterait sur une portion un soufflet métallique de manière à permettre une extension de sa longueur, le deuxième miroir 22 étant alors fixé à la deuxième extrémité de la paroi latérale 23. Selon cette possibilité c'est l'extension de la paroi latérale 23 autorisé par le soufflé métallique qui permet de déplacer le deuxième miroir 22 par rapport au premier miroir 21. Selon une autre possibilité de l'invention non illustrée, il est également envisageable que ce soit le premier miroir 21 qui soit monté mobile par rapport à la paroi latérale 23 et au deuxième miroir 22. Avec cette possibilité, le deuxième miroir 22 est également mobile relativement au premier miroir de manière à permettre de changer la fréquence de résonance de la cavité résonnante 20 et donc de l'accorder en fonction de la première fréquence choisie.

Le montage mobile du deuxième miroir 22 relativement au premier miroir 21 permet donc de modifier la fréquence de résonance de la cavité résonnante 20 par un placement adéquate du deuxième miroir 22 par rapport au premier miroir 21. Ainsi une telle cavité résonnante 20 est apte à présenter une première configuration dans laquelle la cavité résonnante 20 est une cavité résonnante à la première fréquence d'émission et une deuxième configuration dans laquelle la cavité résonnante 20 est une cavité résonnante à une deuxième fréquence d'émission.

Dans ce premier mode de réalisation, l'atmosphère de la cavité résonnante peut être modifiée aussi bien en composition qu'en pression. Pour ce faire, la chambre étanche 24 est munie d'une entrée des gaz 24b et d'une sortie de pompage 24c. Ainsi, avec une cavité résonnante 20 selon ce premier mode de réalisation peut comporter l'ammoniac gazeux en tant que milieu amplificateur choisi dans le groupe comportant l'ammoniac dont l'atome d'azote est l'isotope 14, l'ammoniac dont l'atome d'azote est l'isotope 15 et leur mélange.

Dans le cas où un seul isotope de l'ammoniac est requis, la proportion volumique relative dans le milieu amplificateur de l'un parmi l'ammoniac dont l'atome d'azote est l'isotope 14 et l'ammoniac dont l'atome d'azote est l'isotope 15 est supérieure à 90% et préférentiellement à 95%.

Par contre, dans le cas où il est préféré un mélange des deux isotopes de l'ammoniac, notamment pour donner accès à la fois aux fréquences d'émission admissibles avec l'ammoniac dont l'atome d'azote est l'isotope 14 et avec l'ammoniac dont l'atome d'azote est l'isotope 15, les proportions volumiques relatives dans le milieu amplificateur de l'ammoniac dont l'atome d'azote est l'isotope 14 et l'ammoniac dont l'atome d'azote est l'isotope 15 sont tous deux comprises entre 40 et 60%.

Bien entendu, dans le cas où des propriétés intermédiaire entre celles offertes par ces deux types de proportions volumiques relatives sont recherchées, la proportion volumique relative dans le milieu amplificateur de l'un parmi l'ammoniac dont l'atome d'azote est l'isotope 14 et l'ammoniac dont l'atome d'azote est l'isotope 15 peut être intermédiaire entre celles de ces deux types de proportions volumiques sans que l'on sorte de l'invention.

La pression d'ammoniac dans la cavité résonnante est préférentiellement comprise entre 1 μbar et 1 mbar, préférentiellement entre 10 μbar et 500 μbar. Ainsi, la pression d'ammoniac dans la cavité résonnante peut être par exemple égale à 50 μbar.

L'entrée et cette sortie de gaz 24b, 24c sont reliées respectivement à une source d'ammoniac gazeux et à un système de pompage et permettent de définir l'atmosphère en ammoniac dans la cavité résonnante 20. De cette manière il est possible de modifier les proportions relatives d'ammoniac dont l'azote est l'isotope 14 et d'ammoniac dont l'atome d'azote est l'isotope 15 dans la cavité résonnante 20.

Une telle possibilité de modification du milieu amplificateur de la cavité résonnante 20 est particulièrement avantageuse puisqu'elle permet, en combinaison avec la possibilité d'accorder le rayonnement pompe et la fréquence de résonance de la cavité optique, de rendre accessible à la fois les raies d'émission térahertz de l'ammoniac dont l'azote est l'isotope 14 et celles de l'ammoniac dont l'atome d'azote est l'isotope 15.

On peut noter qu'en alternative, dans le cas par exemple, où seules les raies d'émission du térahertz de l'un de l'ammoniac dont l'azote est l'isotope 14 et de l'ammoniac dont l'atome d'azote est l'isotope 15 est nécessaire, la cavité résonnante 20 peut être scellée hermétiquement, l'atmosphère de la cavité résonnante étant alors prédéfinie.

Afin d'assurer une fermeture hermétique de la deuxième extrémité de la paroi latérale, la cavité résonnante 20 comporte, sur le deuxième miroir, une fenêtre 25 du deuxième miroir 22 au moins partiellement, préférentiellement totalement, transparente aux fréquences du térahertz. La fenêtre 25 du deuxième miroir 20 peut ainsi être une fenêtre en copolymère d'oléfine cyclique (connu sous son sigle COC) ou encore en polypropylène, en quartz, en polyéthylène ou en polyméthylpentène (plus connu sous ses sigles PMP ou TPX).

Une cavité résonnante 20 selon ce premier mode de réalisation couplée optiquement avec une source laser infrarouge 10 accordable, tel qu'un laser à cascade quantique, forme un laser térahertz 1 selon une possibilité de l'invention qui est apte à émettre sur l'ensemble des raies d'émission accessibles de l'ammoniac gazeux dans la gamme du térahertz.

Les figures 4a et 4b illustrent les raies d'émission accessibles aussi bien pour l'ammoniac dont l'azote est l'isotope 14 que l'ammoniac dont l'azote est l'isotope 15 ceci pour une transition d'inversion selon l'invention avec un pompage du milieu amplificateur par une excitation par la banche Q du mode de vibration $v_2$ de l'ammoniac avec J qui reste inférieur ou égal à 10. La figure 4a illustre ainsi graphiquement les raies d'émission de l'ammoniac avec en abscisse la fréquence de l'émission du laser térahertz 1 et en ordonnée le nombre d'onde du rayonnement pompe émis par la source laser infrarouge 10. On peut voir sur ce graphique que les raies d'émission de l'ammoniac dont l'azote est l'isotope 14, représentées par les points noirs, sont réparties sur toute la largeur de la gamme du térahertz. Cette même observation peut être faite pour les raies d'émission de l'ammoniac dont l'azote est l'isotope 15, représentées par les cercles sur la figure 4a. Ainsi, même avec un seul type d'ammoniac, que ce soit l'ammoniac dont l'azote est l'isotope 14 ou l'ammoniac dont l'azote est l'isotope 15, il est possible de fournir un laser térahertz selon l'invention avec une fréquence d'émission choisie dans la gamme du térahertz ceci sans réelle limitation dans le choix de cette fréquence. En effet deux fréquences d'émission accessibles consécutives présentent une différence qui est inférieure à 30 GHz et qui est égale, en moyenne à 15 GHz.

On peut de plus observer, comme cela est illustré sur la figure 4b qui est une frise représentant sur une échelle de fréquence toutes les raies d'émission accessibles selon le principe de l'invention (bande Q et mode de vibration $v_2$=1, J<10), qu'un nombre important de raies d'émission est accessible dans la partie de la gamme de fréquences du térahertz dont la fréquence est inférieure à 1060 GHz. Ceci est particulièrement avantageux, puisque dans cette partie de la gamme du térahertz l'atténuation du rayonnement est relativement faible. En effet, si l'on considère une humidité relative de 50%, l'atténuation passe tour à tour de 0,1 dB/m, à 0,15 dB/m et 0,4 dB/m pour les fréquences respectives de la gamme du térahertz que sont les fréquences 840-860 GHz, 940 GHz et 1025-1040 GHz. Ainsi, cette partie de la gamme du térahertz est particulièrement avantageuse pour effectuer des mesures et/ou de l'imagerie puisqu'il est possible de les réaliser à l'atmosphère ambiante et ne nécessite donc pas d'atmosphère particulière telle qu'une atmosphère asséchée ou faible pression, c'est-à-dire inférieur à l'atmosphérique.

De même, les lasers térahertz 1 selon l'invention, de par cette densité importante de raies d'émission, notamment en raison de l'isotopie de l'azote, permet de bénéficier dans la gamme du térahertz de plusieurs doublés de raies d'émission, et donc de lasers térahertz, dont la différence de fréquence d'émission est inférieure à 1 GHz. Les lasers térahertz selon l'invention sont donc adaptés pour leur utilisation dans un récepteur hétérodyne dans la gamme du térahertz. Une telle utilisation peut se faire en combinant les deux faisceaux de deux lasers térahertz de fréquence d'émission proches (différence inférieure à 1 GHz) au moyen d'un mélangeur, par exemple une diode Schottky, et d'ainsi générer cette différence de fréquence. Cette différence de fréquence peut ensuite être amplifiée électroniquement de manière à autoriser la détection de l'un des deux faisceaux.

C'est cette possibilité qui est démontré dans le tableau 1 ci-dessous qui liste les différents doublés de raies d'émission qui pourraient être utilisés pour une telle application. On notera qu'il s'agit ici uniquement des doublés se trouvant dans la gamme du térahertz et dont les fréquences sont inférieures à 1040 GHz correspondant à l'application usuelle de l'invention, c'est-à-dire le mode de vibration $v_2$=1 pour une excitation par la branche Q et un J inférieur à 10.

Tableau 1 : doublés de raies laser ayant une différence de fréquence inférieure à 1 GHz dans la gamme de fréquences du térahertz et dont les fréquences sont inférieures à 1,04 THz, la première raie de chaque doublé étant une raie accessible avec l'ammoniac dont l'azote est l'isotope 14 tandis que la deuxième raie de chaque doublé est une raie accessible avec l'ammoniac dont l'azote est l'isotope 15.

| | $^{14}NH_3$ | | $^{15}NH_3$ | | |
| --- | --- | --- | --- | --- | --- |
| | f(GHz) | Etat vibrationnel supérieur | f(GHz) | Etat vibrationnel supérieur | Δf(MHz) |
| f1 | 921,95 | v2=1 a(6,3) | 922,01 | v2=1 a(8,6) | -60 |

(suite)

| | $^{14}NH_3$ | | $^{15}NH_3$ | | |
|---|---|---|---|---|---|
| | f(GHz) | Etat vibrationnel supérieur | f(GHz) | Etat vibrationnel supérieur | $\Delta f$(MHz) |
| f2 | 925,66 | v2=1 a(5,1) | 925,28 | v2=1 a(7,5) | 380 |
| f3 | 958,83 | v2=1 a(8,6) | 958,23 | v2=1 a(4,2) | 600 |
| f4 | 994,75 | v2=1 a(4,2) | 994,65 | v2=1 a(6,5) | 100 |
| f5 | 1029,37 | v2=1 a(5,4) | 1029,22 | v2=1 a(1,1) | 150 |
| f6 | 1030,53 | v2=1 a(4,3) | 1030,12 | v2=1 a(2,2) | 410 |
| f7 | 1035,82 | v2=1 a(3,2) | 1035,21 | v2=1 a(3,3) | 610 |

Bien entendu, si dans le premier mode de réalisation de l'invention, la cavité résonnante est une cavité dont la fréquence de résonnance peut être modifiée, l'invention englobe également les lasers térahertz dont la cavité résonnante 20 présente une seule et unique configuration. Dans cette configuration, la cavité résonnante 20 est une cavité résonnante à la première fréquence d'émission.

La figure 5 illustre expérimentalement la puissance d'émission d'un laser selon l'invention obtenue par les inventeurs dans une configuration similaire à celle du premier mode de réalisation et illustrée sur la figure 3. Lors de ces mesures, les inventeurs ont démontré l'effet laser pour deux fréquences d'émission qui sont celles qui correspondent aux schémas énergétiques illustrés sur la figure 2. Ainsi, il s'agit dans les deux cas d'une excitation des molécules d'ammoniac dans le mode de vibration par la branche Q, le premier dans l'état vibrationnel $v_2$=1 a(3,2) (noté sur la figure asQ(3,2) et représenté par des points noirs), le deuxième dans l'état de vibrationnel $v_2$=1 a(3,2) (noté sur la figure asQ(3,3) et représenté par des carrés noirs).

La configuration précise de la cavité résonnante utilisée lors de ces expérimentations est la suivante :

- la paroi latérale 23 est une paroi latérale tubulaire à section circulaire 23 en cuivre qui présente un diamètre intérieur de 10 mm et une longueur de cavité de 50 cm,
- chacun des premier et deuxième miroirs 21, 22 est un miroir en laiton avec une ouverture 21a, 22a de 1,2 mm de diamètre pour respectivement l'introduction du rayonnement pompe et l'extraction du rayonnement laser,
- la pression en ammoniac gazeux est maintenue dans la cavité résonnante de 20 à 100 $\mu$bar.

On peut voir sur la figure 5 que l'effet laser apparait aussi bien pour la transition asQ(3,2) que pour la transition asQ(3,3) à une puissance de pompage de 2-3 mW et qu'en raison d'une ouverture symétrique au niveau du premier et deuxième miroir 21, 22, la puissance émise est divisée par deux. On atteint ainsi en réalité des puissances de l'ordre de 16-18 $\mu$W pour un pompage avec un rayonnement infrarouge d'environ 25 mW. Les rendements atteints lors de cette expérimentation d'un laser selon l'invention sont donc relativement important et les puissances de pompe seuil relativement faibles vis-à-vis de ceux d'un laser térahertz de l'art antérieur.

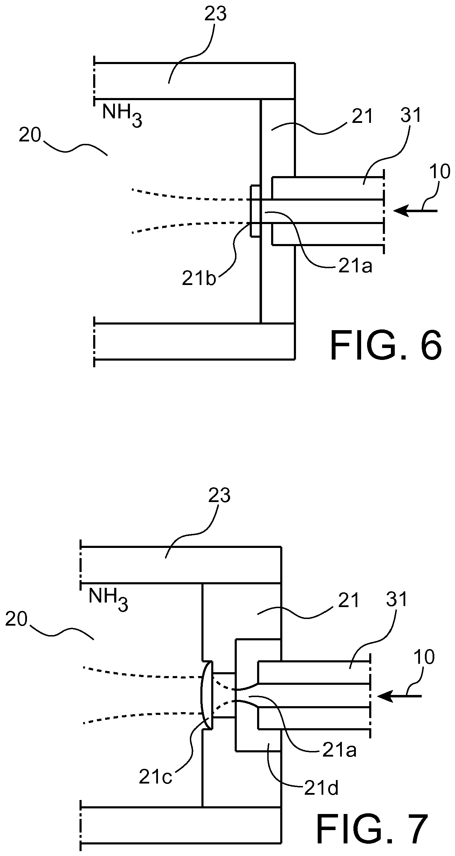

La figure 6 illustre le couplage optique entre une cavité résonnante 20 et une source laser infrarouge 10 selon un deuxième mode de réalisation. Un laser térahertz 1 selon ce deuxième mode de réalisation se différencie en ce que la cavité résonnante 20 et la source laser infrarouge sont couplées optiquement l'une à l'autre par une fibre optique infrarouge 31.

Dans la figure 6, la fibre optique infrarouge 31 est une fibre optique infrarouge du type creuse, c'est-à-dire que le coeur de fibre est constitué d'air. On peut néanmoins noter que si c'est une fibre optique dite creuse qui est illustrée sur la figure 6, d'autres fibres optiques infrarouge sont envisageables sans sortir du cadre de l'invention. Ainsi la fibre optique infrarouge peut également être, par exemple, une fibre optique à verre de chalcogénure ou une fibre optique microstructurée.

Pour permettre un tel couplage de la source laser infrarouge 10 à la cavité résonnante 20 par la fibre optique infrarouge 31, la fibre optique 31 comporte une première et une deuxième extrémité connectées respectivement à la sortie de la source laser infrarouge 10 et à l'ouverture du premier miroir 21 de la cavité résonnante 20. Afin de loger la deuxième extrémité de la fibre optique infrarouge 31, le premier miroir 21 comporte, sur sa face opposée au deuxième miroir 22, une cavité d'accueil. Une telle cavité d'accueil permet de faciliter le placement de la deuxième extrémité de la fibre optique infrarouge 31 de manière à ce que cette dernière soit parfaitement alignée par rapport à l'ouverture 21a du premier miroir 21.

Dans le cas de la fibre optique infrarouge 31 du type creuse illustrée sur la figure 6, afin de limiter les risques de fuites au niveau de la fibre optique infrarouge 31, cette dernière étant creuse, l'ouverture 21a du premier miroir 21 est fermée hermétiquement par une fenêtre transparente 21b au rayonnement infrarouge, par exemple en bromure de potassium. De même et de manière identique au premier mode de réalisation, le taux de réflexion du premier miroir 21 peut être optimisé avec une ouverture 21a du premier miroir 21 dont les dimensions sont inférieures à 176 µm et supérieures à 40 µm. Cette ouverture 21a du premier miroir peut ainsi être un orifice circulaire dont le diamètre est compris entre 176 µm et 40 µm. Ainsi, l'orifice 21a ne laisse pas passer le rayonnement laser issu de la transition d'inversion des molécules d'ammoniac alors qu'il autorise l'introduction du rayonnement de pompe dont la longueur d'onde est inférieure à 70 µm.

La figure 7 illustre un laser térahertz 1 selon un troisième mode de réalisation dans lequel le couplage optique par la fibre optique infrarouge 31 est optimisé. Un laser térahertz 1 selon ce troisième mode de réalisation se différencie d'un laser térahertz 1 selon le deuxième mode de réalisation en ce que le premier miroir comporte une pièce d'adaptation 21d afin d'améliorer la transmission du rayonnement pompe par l'ouverture 21a du premier miroir 21 et une lentille convergente 21c afin de compenser la divergence du rayonnement pompe lors de son passage par la pièce d'adaptation 21d du premier miroir 21.

Le premier miroir comporte, au niveau de son ouverture 21a, une cavité d'accueil pour la pièce d'adaptation 21d, cette dernière pièce accueillant elle-même la fibre optique infrarouge 31. La pièce d'adaptation 21d est réalisée dans un matériau au moins partiellement réfléchissant dans la de l'infrarouge du rayonnement de pompe et préférentiellement totalement réfléchissant dans cette même gamme de fréquences. La pièce d'adaptation comporte un orifice d'introduction pour permettre l'injection du rayonnement pompe. Cet orifice d'introduction présente les mêmes contraintes dimensionnelles que l'ouverture 21a du premier miroir 21 selon le deuxième mode de réalisation. L'orifice de la pièce d'adaptation 21d peut ainsi être circulaire avec un diamètre minimal, en direction du deuxième miroir 22, compris 176 µm et 40 µm. L'orifice, de manière à améliorer l'injection du rayonnement pompe dans la cavité optique, comporte une section conique avec un diamètre maximal, en regard de la fibre optique infrarouge 31, sensiblement égal au coeur de la fibre optique, ici la cavité guidante de la fibre optique infrarouge 31 du type creuse.

L'orifice de la pièce d'adaptation 21d ayant pour fonction de ne pas laisser passer le rayonnement térahertz, l'ouverture 21a ne présente pas de contrainte dimensionnelle particulière. Le premier miroir 21 présente, en sortie de l'ouverture 21a, un épaulement pour loger la lentille convergente 21c. La focale de la lentille convergente 21c est préférentiellement dépendante des dimensions de l'orifice de la pièce d'adaptation 21d de manière à diminuer la divergence du rayonnement pompe lors de son injection dans la cavité résonnante 20. En variante, il également possible de placer entre la fibre 31 et la pièce 21d une ou plusieurs lentilles convergentes afin de focaliser le faisceau infrarouge de pompe dans le diamètre minimal de la pièce 21d.

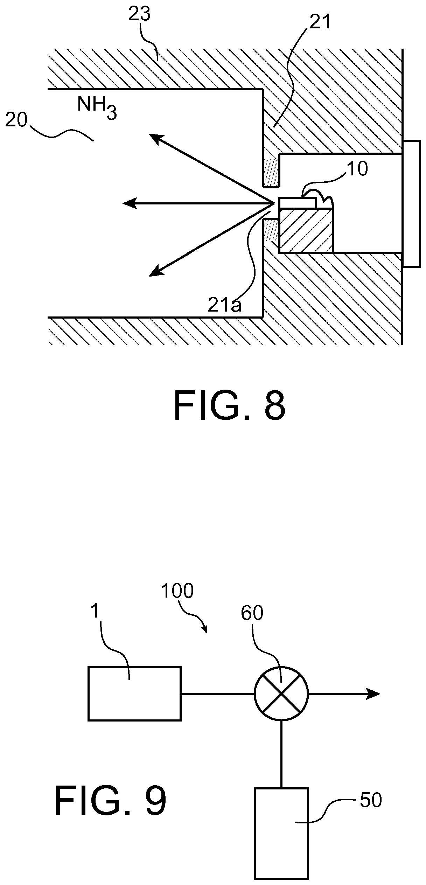

La figure 8 illustre un quatrième mode de réalisation de l'invention dans lequel la sortie de la source laser infrarouge 10 est directement positionnée au niveau de l'ouverture du premier miroir 21, c'est-à-dire de l'entrée de la cavité résonnante 20. Un laser térahertz 1 selon ce quatrième mode de réalisation se différencie d'un laser térahertz selon le deuxième mode de réalisation en ce qu'il ne nécessite pas de dispositif de couplage optique entre la source laser infrarouge 10 et la cavité résonnante 20, tel que des miroirs 30 ou une fibre optique infrarouge 31, le couplage optique étant directement fourni par le placement de la source laser infrarouge 10 par rapport à la cavité résonnante 20.

Un tel mode de réalisation est plus particulièrement adapté pour les sources laser infrarouge à semiconducteur libre de cavité résonnante externe et donc avec une sortie optique particulièrement divergente. Ainsi avec un tel agencement de la sortie de la source laser infrarouge 10 par rapport à l'entrée de la cavité résonnante 20, c'est-à-dire, sur la figure 8 l'ouverture 21a du premier miroir 21, la totalité du cône d'émission de la source laser infrarouge est injectée dans la cavité résonnante 20.

Afin d'assurer l'étanchéité, il est prévu comme le montre la figure 8, dans le prolongement de la cavité et du premier miroir un logement étanche adapté pour recevoir la source laser infrarouge 10. En variante, il est bien entendu possible, de la même façon que pour le deuxième mode de réalisation de munir l'ouverture 21a du premier miroir 21 d'une fenêtre transparente aux infrarouges ou d'utiliser une combinaison de lentilles pour focaliser le rayonnement infrarouge dans l'ouverture 21a.

La figure 9 est un schéma de principe d'une source térahertz 100 adapte à émettre dans la gamme du térahertz, ladite source térahertz 100 comportant :

- un laser térahertz 1 selon l'invention, tel que par exemple l'un parmi ceux du premier au cinquième mode de réalisation,
- une source hyperfréquence 50 apte à émettre un rayonnement électromagnétique compris entre 1 GHz et 200 GHz préférentiellement entre 1 et 50 GHz,
- un milieu ou dispositif non linéaire 60, tel qu'une diode Schottky, agencé pour mélanger le rayonnement térahertz du laser térahertz et le rayonnement hyperfréquence pour fournir le deuxième rayonnement térahertz dont la fréquence d'émission correspond à la fréquence d'émission du rayonnement térahertz à laquelle a été ajoutée ou retranchée celle du rayonnement électromagnétique émis par la source hyperfréquence 50.

Une telle source térahertz 100 permet de fournir une source de rayonnement électromagnétique dans la gamme du térahertz dont la fréquence d'émission est en dehors des raies d'émission accessible par une transition d'inversion pure de l'ammoniac. On peut donc, en combinant une source laser térahertz selon l'invention et une source hyperfréquence accordable en fréquence couvrir l'ensemble de la gamme du térahertz. Une telle source térahertz 100 peut permettre de développer de nouveaux systèmes de mesure, tels que des spectrométres térahertz, qui n'ont pu voir le jour jusqu'ici faute de sources térahertz adaptées, notamment en puissance.

Selon une possibilité de l'invention, non illustrée, afin d'assurer une inversion de population adéquate des molécules du milieu amplificateur et limiter les risques d'accumulation de molécules dans le niveau énergétique dans lequel elle se trouve après la désexcitation par une transition d'inversion, il peut être prévu une deuxième source laser. Cette deuxième source laser présente au moins une configuration dans laquelle elle émet un rayonnement dont la longueur d'onde correspond sensiblement à la différence d'énergie entre le rayonnement émis par la source laser infrarouge et celui émis par le laser térahertz. De cette manière, cette deuxième source laser va permettre de stimuler une transition des molécules du milieu amplificateur du niveau énergétique dans lequel elle se trouve après la désexcitation par une transition d'inversion vers le niveau initial. Une telle possibilité permet de limiter le temps de vie moyen d'une molécule dans le niveau énergétique dans lequel elle se trouve après la désexcitation par une transition d'inversion et d'augmenter le nombre de molécules susceptibles d'être placées dans le premier niveau excité par le pompage au moyen de la source laser infrarouge.

Dans les modes de réalisation décrits ci-dessus, l'injection du rayonnement pompe a lieu à une extrémité de la cavité résonnante selon une direction longitudinale de la cavité optique. Il est néanmoins également envisageable, sans que l'on sorte du cadre de l'invention, que l'injection du rayonnement pompe soit réalisée selon une géométrie différente. En effet, cette injection peut également avoir lieu selon une direction inclinée par rapport à l'axe longitudinal. Une telle configuration, pouvant alors se faire par des ouvertures latérales aménagées dans la paroi latérale, elle présente l'avantage de permettre un pompage par plusieurs sources laser infrarouge.

Donc, de la même façon, si dans les modes de réalisation décrits ci-dessus, une seule source laser infrarouge est mise en oeuvre pour le pompage optique de la cavité optique, il est également envisageable, sans que l'on sorte du cadre de l'invention, que le laser térahertz comprennent deux, ou plus, sources laser infrarouge pour pomper la cavité optique. Bien entendu, il s'agit ici de plusieurs sources laser infrarouge émettant à la même longueur d'onde afin d'obtenir un pompage plus efficace de la cavité résonnante et non un pompage à deux longueurs d'onde comme c'est le cas pour certains lasers térahertz de l'art antérieur.

On peut également noter que si les lasers térahertz selon l'invention sont principalement dédiés à fournir un rayonnement continu, un tel laser peut être adapté pour fournir un rayonnement pulsé par l'utilisation d'un obturateur, tel qu'un modulateur acousto-optique ,électro-optique ou élasto-optique, obturant de manière régulière, soit le rayonnement pompe fourni par la source laser infrarouge, soit le rayonnement térahertz émis par le laser lui-même. Bien entendu, quelle que soit la solution retenue, la source laser infrarouge d'un laser selon l'invention reste une source laser infrarouge continue à semiconducteur.

Le laser térahertz 1 selon l'invention est particulièrement dédié aux applications optiques du térahertz que sont l'imagerie, la spectroscopie, la transmission de données et la détection d'obstacles dans la gamme du térahertz.

**Revendications**

**1.** Laser térahertz (1) adapté pour émettre au moins un premier rayonnement électromagnétique dont une première fréquence d'émission est comprise entre 700 GHz et 1200 GHz, ledit laser comportant :

- une source laser infrarouge (10),
- une cavité résonnante (20) agencée pour être pompée optiquement par la source laser infrarouge (10), ladite cavité optique résonnante (20) contenant de l'ammoniac gazeux en tant que milieu amplificateur et présentant au moins une configuration pour laquelle la cavité résonnante (20) est une cavité résonnante à la première fréquence d'émission,

le laser térahertz (1) **étant caractérisé en ce que** la source laser infrarouge (10) est une source laser à semiconducteur continue apte à exciter les molécules du milieu amplificateur d'un niveau énergétique initial vers au moins un premier niveau énergétique excité, les molécules du milieu amplificateur placées dans ce premier niveau énergétique excité étant susceptibles de se désexciter par une transition d'inversion pure liée au mode de renversement de type parapluie de la molécule d'ammoniac, dont l'énergie de désexcitation correspond à la première fréquence d'émission.

**2.** Laser térahertz (1) selon la revendication 1 dans lequel la source laser infrarouge (10) est un laser à cascade quantique.

**3.** Laser térahertz (1) selon la revendication 2 adapté pour émettre au moins un deuxième rayonnement électromagnétique dont une deuxième fréquence d'émission est comprise entre 700GHz et 1200 GHz, dans lequel la source laser infrarouge (10) est un laser à cascade quantique accordable sur une plage de longueurs d'onde comportant au moins deux longueurs d'onde aptes à exciter les molécules du milieu amplificateur du niveau énergétique initial vers respectivement le premier et un deuxième niveau énergétique excité, les molécules du milieu amplificateur placées dans ce deuxième niveau énergétique excité étant susceptibles de se désexciter par une transition d'inversion pure liée au mode de renversement de type parapluie de la molécule d'ammoniac dont l'énergie de désexcitation correspond à la deuxième fréquence d'émission,
la cavité résonnante (20) présentant au moins une configuration pour laquelle la cavité résonnante (20) est une cavité résonnante à la deuxième fréquence d'émission.

**4.** Laser térahertz (1) selon l'une quelconque des revendications 1 à 3, dans lequel le premier niveau énergétique excité par la source laser infrarouge (10) est un niveau énergétique de vibration $v_2=1$ accessible par une transition de la branche Q avec un nombre quantique J inférieur à 10.

**5.** Laser térahertz (1) selon l'une quelconque des revendications 1 à 4, dans lequel l'ammoniac gazeux est choisi dans le groupe comportant l'ammoniac dont l'atome d'azote est l'isotope 14, l'ammoniac dont l'atome d'azote est l'isotope 15 et leur mélange,
et dans lequel la proportion volumique relative dans le milieu amplificateur de l'un parmi l'ammoniac dont l'atome d'azote est l'isotope 14 et l'ammoniac dont l'atome d'azote est l'isotope 15 est supérieure à 90% et préférentiellement à 95%.

**6.** Laser térahertz (1) selon l'une quelconque des revendications 1 à 4, dans lequel l'ammoniac gazeux est un mélange d'ammoniac dont l'atome d'azote est l'isotope 14 et d'ammoniac dont l'atome d'azote est l'isotope 15, les proportions volumiques relatives dans le milieu amplificateur de l'ammoniac dont l'atome d'azote est l'isotope 14 et l'ammoniac dont l'atome d'azote est l'isotope 15 étant toutes deux comprises entre 40 et 60%.

**7.** Laser térahertz (1) selon l'une quelconque des revendications 1 à 4, dans lequel l'ammoniac gazeux est un mélange d'ammoniac dont l'atome d'azote est l'isotope 14 et d'ammoniac dont l'atome d'azote est l'isotope 15, la cavité résonnante (20) étant configurée pour permettre une modification des proportions volumiques relatives dans le milieu amplificateur de l'ammoniac dont l'atome d'azote est l'isotope 14 et l'ammoniac dont l'atome d'azote est l'isotope 15.

**8.** Laser térahertz (1) selon l'une quelconque des revendications 1 à 7 comportant au moins une fibre optique infrarouge (31), telle qu'une fibre optique creuse, comprenant une première et une deuxième extrémité, la première extrémité étant connectée à la sortie de la source laser infrarouge (10) et la deuxième extrémité étant connectée à la cavité résonnante (20) de manière à fournir une liaison optique entre la source laser infrarouge (10) et la cavité résonnante (20).

**9.** Laser térahertz (1) selon l'une quelconque des revendications 1 à 8 dans lequel la source laser infrarouge (10) est adaptée pour émettre un rayonnement pompe pour pomper optiquement la cavité résonnante (20),
et dans lequel la cavité résonnante (20) comporte une entrée, de forme circulaire ou rectangulaire, pour l'injection du rayonnement pompe dont les dimensions sont inférieures à $c/1,706f$ avec c la vitesse de la lumière et f la première fréquence d'émission, les dimensions de l'entrée pour l'injection du rayonnement pompe étant préférentiellement inférieures à $c/2f$.

**10.** Laser térahertz (1) selon l'une quelconque des revendications 1 à 9, dans lequel la sortie de la source laser infrarouge (10) est positionnée au niveau de l'entrée de la cavité résonnante (20).

**11.** Laser térahertz (1) selon la revendication 9 ou 10, dans lequel la cavité résonnante (20) comporte une lentille convergente (21c) agencée pour diminuer la divergence du rayonnement pompe en sortie de la fenêtre d'entrée.

**12.** Source térahertz (100) adaptée pour émettre au moins un troisième rayonnement électromagnétique dont une troisième fréquence d'émission est comprise entre 700 GHz et 1200 GHz, la source térahertz (100) comportant :

- un laser térahertz (1) selon l'une quelconque des revendications 1 à 11,

- une source hyperfréquence apte à émettre un rayonnement hyperfréquence dont la fréquence d'émission est comprise entre 1 GHz et 200 GHz,
- un milieu ou dispositif non linéaire agencé pour mélanger le premier rayonnement térahertz fourni par le laser térahertz (1) et le rayonnement hyperfréquence pour fournir le troisième rayonnement.

13. Utilisation d'un laser térahertz (1) selon l'une des revendications 1 à 11 pour effectuer de l'imagerie, de la spectroscopie, de la transmission de données ou de la détection d'obstacles dans la gamme du térahertz.

**Patentansprüche**

1. Terahertzlaser (1), der dazu geeignet ist, wenigstens eine erste elektromagnetische Strahlung mit einer ersten Sendefrequenz zwischen 700 GHz und 1200 GHz auszusenden, wobei der Laser umfasst:

   - eine Infrarot-Laserquelle (10),
   - einen Resonanzhohlraum (20), der angeordnet ist, um von der Infrarot-Laserquelle (10) optisch gepumpt zu werden, wobei der Resonanzhohlraum (20) gasförmiges Ammoniak als Verstärkermedium enthält und wenigstens eine Konfiguration darstellt, in der der Resonanzhohlraum (20) ein Resonanzhohlraum für die erste Sendefrequenz ist,

   wobei der Terahertzlaser (1) **dadurch gekennzeichnet ist, dass** die Infrarot-Laserquelle (10) eine kontinuierliche Halbleiter-Laserquelle ist, die dazu geeignet ist, die Moleküle des Verstärkermediums von einem Anfangs-Energieniveau auf wenigstens ein erstes angeregtes Energieniveau anzuregen, wobei die Moleküle des Verstärkermediums, die sich auf diesem ersten angeregten Energieniveau befinden, leicht durch einen reinen Inversionsübergang in einen Grundzustand überführen lassen, der mit dem schirmartigen Umkehrmodus des Ammoniakmoleküls verbunden ist, dessen Relaxationsenergie der ersten Sendefrequenz entspricht.

2. Terahertzlaser (1) nach Anspruch 1, wobei die Infrarot-Laserquelle (10) ein Quantenkaskadenlaser ist.

3. Terahertzlaser (1) nach Anspruch 2, der dazu geeignet ist, wenigstens eine zweite elektromagnetische Strahlung mit einer zweiten Sendefrequenz zwischen 700 GHz und 1200 GHz auszusenden, wobei die Infrarot-Laserquelle (10) ein Quantenkaskadenlaser ist, der über einen Wellenlängenbereich abstimmbar ist, der wenigstens zwei Wellenlängen enthält, die dazu geeignet sind, die Moleküle des Verstärkermediums von dem Anfangs-Energieniveau auf das erste angeregte bzw. ein zweites angeregtes Energieniveau anzuregen, wobei die Moleküle des Verstärkermediums, die sich auf dem zweiten angeregten Energieniveau befinden, leicht durch einen reinen Inversionsübergang in einen Grundzustand überführen lassen, der mit dem schirmartigen Umkehrmodus des Ammoniakmoleküls verbunden ist, dessen Relaxationsenergie der zweiten Sendefrequenz entspricht, wobei der Resonanzhohlraum (20) wenigstens eine Konfiguration darstellt, in der der Resonanzhohlraum (20) ein Resonanzhohlraum für die zweite Sendefrequenz ist.

4. Terahertzlaser (1) nach einem der Ansprüche 1 bis 3, wobei das erste Energieniveau, das durch die Infrarot-Laserquelle (10) angeregt wird, ein Energieniveau der Schwingung v2=1 ist, das durch einen Übergang des Q-Zweigs mit einer Quantenzahl J kleiner 10 zugänglich ist.

5. Terahertzlaser (1) nach einem der Ansprüche 1 bis 4, wobei das gasförmige Ammoniak aus der Gruppe ausgewählt ist, die Ammoniak mit dem Stickstoffisotop 14, Ammoniak mit dem Stickstoffisotop 15 und ihre Mischung enthält, und wobei der relative Volumenanteil in dem Verstärkermedium von einem von dem Ammoniak mit dem Stickstoffisotop 14 und dem Stickstoffisotop 15 über 90% und vorzugsweise über 95% beträgt.

6. Terahertzlaser (1) nach einem der Ansprüche 1 bis 4, wobei das gasförmige Ammoniak eine Mischung ist aus Ammoniak mit dem Stickstoffisotop 14 und Ammoniak mit dem Stickstoffisotop 15 ist, wobei die relativen Volumenanteile in dem Verstärkermedium von dem Ammoniak mit dem Stickstoffisotop 14 und dem Ammoniak mit dem Stickstoffisotop 15 jeweils zwischen 40 und 60% betragen.

7. Terahertzlaser (1) nach einem der Ansprüche 1 bis 4, wobei das gasförmige Ammoniak eine Mischung ist aus Ammoniak mit dem Stickstoffisotop 14 und Ammoniak mit dem Stickstoffisotop 15 ist, wobei der Resonanzhohlraum (20) konfiguriert ist, um eine Modifikation der relativen Volumenanteile in dem Verstärkermedium des Ammoniaks mit dem Stickstoffisotop 14 und des Ammoniaks mit dem Stickstoffisotop 15 zu ermöglichen.

8. Terahertzlaser (1) nach einem der Ansprüch 1 bis 7, der wenigstens einen Infrarot-Lichtleitfaser (31), wie etwa eine optische Hohlfaser, mit einem ersten und einem zweiten Ende umfasst, wobei das erste Ende mit dem Ausgang der Infrarot-Laserquelle (10) und das zweite Ende mit dem Resonanzhohlraum (20) verbunden ist, um so eine optische Verbindung zwischen der Infrarot-Laserquelle (10) und dem Resonanzhohlraum (20) herzustellen.

9. Terahertzlaser (1) nach einem der Ansprüche 1 bis 8, wobei die Infrarot-Laserquelle (10) dazu geeignet ist, eine Pumpstrahlung zum optischen Pumpen des Resonanzhohlraums (20) auszusenden,
und wobei der Resonanzhohlraum (20) einen kreisförmigen oder rechteckigen Eingang zum Einkoppeln der Pumpstrahlung aufweist, dessen Abmessungen kleiner als c/1,706f sind, wobei c die Lichtgeschwindigkeit und f die erste Sendefrequenz ist und wobei die Abmessungen des Eingangs zum Einkoppeln der Pumpstrahlung vorzugsweise kleiner als c/2f sind.

10. Terahertzlaser (1) nach einem der Ansprüche 1 bis 9,
wobei der Ausgang der Infrarot-Laserquelle (10) auf Höhe des Eingangs des Resonanzhohlraums (20) angeordnet ist.

11. Terahertzlaser (1) nach Anspruch 9 oder 10, wobei der Resonanzhohlraum (20) eine Sammellinse (21c) zum Verringern der Divergenz der Pumpstrahlung am Ausgang des Eingangsfensters umfasst.

12. Teraherzquelle (100), die dazu geeignet ist, wenigstens eine dritte elektromagnetische Strahlung mit einer dritten Sendefrequenz zwischen 700 GHz und 1200 G Hz auszusenden, wobei die Teraherzquelle (100) umfasst:

- einen Terahertzlaser (1) nach einem der Ansprüche 1 bis 11,
- eine Mikrowellenquelle zum Aussenden einer Mikrowellenstrahlung mit einer Sendefrequenz zwischen 1G Hz und 200 GHz,
- ein nichtlineares Medium oder eine nichtlineare Vorrichtung zum Mischen der ersten Terahertzstrahlung von dem Terahertzlaser (1) und der Mikrowellenstrahlung, um die dritte Strahlung zu erzeugen.

13. Verwendung eines Terahertzlasers (1) nach einem der Ansprüche 1 bis 11 zur Durchführung einer Bildgebung, einer Spektroskopie, einer Datenübertragen oder einer Hinderniserkennung im Terahertzbereich.

**Claims**

1. A terahertz laser (1) adapted to emit at least a first electromagnetic radiation a first emission frequency of which is between 700 GHz and 1200 GHz, said laser including:

- an infrared laser source (10),
- a resonant cavity (20) arranged to be optically pumped by the infrared laser source (10), said resonant optical cavity (20) containing ammonia gas as an amplifier medium and having at least one configuration for which the resonant cavity (20) is a resonant cavity at the first emission frequency,

the terahertz laser (1) **being characterised in that** the infrared laser source (10) is a continuous semiconductor laser source capable of exciting the molecules of the amplifier medium from an initial energy level to at least a first excited energy level, the molecules of the amplifier medium placed in this first excited energy level being likely to be de-excited by a pure inversion transition related to the umbrella type inversion mode of the ammonia molecule, the de-excitation energy of which corresponds to the first emission frequency.

2. The terahertz laser (1) according to claim 1, wherein the infrared laser source (10) is a quantum cascade laser.

3. The terahertz laser (1) according to claim 2, adapted to emit at least a second electromagnetic radiation a second emission frequency of which is between 700 GHz and 1200 GHz, wherein the infrared laser source (10) is a quantum cascade laser tunable to a wavelength range including at least two wavelengths capable of exciting the molecules of the amplifier medium from the initial energy level to the first and a second excited energy level respectively, the molecules of the amplifier medium placed in this second excited energy level being likely to be de-excited by a pure inversion transition related to the umbrella type inversion mode of the ammonia molecule the de-excitation energy of which corresponds to the second emission frequency,
the resonant cavity (20) having at least one configuration for which the resonant cavity (20) is a resonant cavity at the second emission frequency.

4. The terahertz laser (1) according to any of claims 1 to 3, wherein the first energy level excited by the infrared laser source (10) is an energy level of vibration v2=1 accessible by a transition of the branch Q with a quantum number J lower than 10.

5. The terahertz laser (1) according to any of claims 1 to 4, wherein the ammonia gas is chosen from the group including ammonia the nitrogen atom of which is the isotope 14, ammonia the nitrogen atom of which is the isotope 15 and a mixture thereof,
and wherein the relative volume proportion in the amplifier medium of one from ammonia the nitrogen atom of which is the isotope 14 and ammonia the nitrogen atom of which is the isotope 15 is higher than 90 % and preferentially than 95 %.

6. The terahertz laser (1) according to any of claims 1 to 4, wherein the ammonia gas is a mixture of ammonia the nitrogen atom of which is the isotope 14 and ammonia the nitrogen atom of which is the isotope 15, the relative volume proportions in the amplifier medium of ammonia the nitrogen atom of which is the isotope 14 and ammonia the nitrogen atom of which is the isotope 15 being both between 40 and 60 %.

7. The terahertz laser (1) according to any of claims 1 to 4, wherein the ammonia gas is a mixture of ammonia the nitrogen atom of which is the isotope 14 and ammonia the nitrogen atom of which is the isotope 15, the resonant cavity (20) being configured to enable the relative volume proportions in the amplifier medium of ammonia the nitrogen atom of which is the isotope 14 and ammonia the nitrogen atom of which is the isotope 15 to be modified.

8. The terahertz laser (1) according to any of claims 1 to 7, including at least one infrared optical fibre (31), such as a hollow optical fibre, comprising a first and a second end, the first end being connected to the outlet of the infrared laser source (10) and the second end being connected to the resonant cavity (20) so as to provide an optical connection between the infrared laser source (10) and the resonant cavity (20).

9. The terahertz laser (1) according to any of claims 1 to 8, wherein the infrared laser source (10) is adapted to emit a pump radiation to optically pump the resonant cavity (20),
and wherein the resonant cavity (20) includes an inlet of circular or rectangular shape for injecting the pump radiation the dimensions of which are lower than $c/1,706f$ with c being the velocity of light and f the first emission frequency, the dimensions of the inlet for injecting the pump radiation being preferentially lower than $c/2f$.

10. The terahertz laser (1) according to any of claims 1 to 9, wherein the outlet of the infrared laser source (10) is positioned at the inlet of the resonant cavity (20).

11. The terahertz laser (1) according to claim 9 or 10, wherein the resonant cavity (20) includes a converging lens (21c) arranged to decrease the divergence of the pump radiation at the outlet of the inlet window.

12. A terahertz source (100) adapted to emit at least a third electromagnetic radiation a third emission frequency of which is between 700 GHz and 1200 GHz, the terahertz source (100) including:

   - a terahertz laser (1) according to any of claims 1 to 11,
   - a hyperfrequency source capable of emitting a hyperfrequency radiation the emission frequency of which is between 1 GHz and 200 GHz,
   - a non-linear medium or device arranged to mix the first terahertz radiation provided by the terahertz laser (1) and the hyperfrequency radiation to provide the third radiation.

13. A use of a terahertz laser (1) according to one of claims 1 to 11, to perform imaging, spectroscopy, data transmission or obstacle detection in the terahertz range.

FIG. 1

FIG. 2

FIG. 3

FIG. 4a

FIG. 4b

FIG. 5

23

20

NH$_3$

21

31

10

21b

21a

FIG. 6

23

20

NH$_3$

21

31

10

21c

21d

21a

FIG. 7

# FIG. 8

# FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BELKIN.** *Nature Photonics,* vol. 1, 288-292

- **Q. Y. LU.** *Applied Physics Letters,* 2012, vol. 101 (1-4), 251121